# EUROPEAN PATENT SPECIFICATION

(11) **EP 4 191 619 B1**
(45) Date of publication and mention of the grant of the patent: **26.03.2025**
(21) Application number: 21306676.4
(22) Date of filing: 01.12.2021
(51) Int. Cl.: H01F 19/04, H01F 27/28, H01P 1/18, H01P 5/18, H03H 7/20, H01F 30/02

(54) **TRANSFORMER**
TRANSFORMATOR
TRANSFORMATEUR

(43) Date of publication of application: 07.06.2023
(73) Proprietor: NXP B.V., 5656 AG Eindhoven (NL)
(72) Inventor: Tesson, Olivier, 31023 Toulouse (FR); Giannakidis, Konstantinos, 31023 Toulouse (FR)
(74) Representative: Miles, John Richard

(56) References cited:
- US-A1- 2019 068 166
- US-B2- 9 159 484

## Description

### FIELD OF THE DISCLOSURE

The present disclosure relates to a transformer. In particular, but not exclusively, it relates to a monolithic autotransformer suitable for providing a small, negative value magnetic coupling coefficient.

### BACKGROUND OF THE DISCLOSURE

There exist many ways to design on-chip monolithic transformers. The main electrical parameters of interest to a circuit designer are the transformer turns ratio n and the coefficient of magnetic coupling k. If the magnetic coupling between windings is perfect (i.e., no leakage of the magnetic flux), k is unity, while uncoupled coils have a k-factor of zero. A practical transformer will have a k-factor between these two extremes. Typically for on-chip monolithic transformers, a k-factor between 0.7 and 0.85 can be achieved.

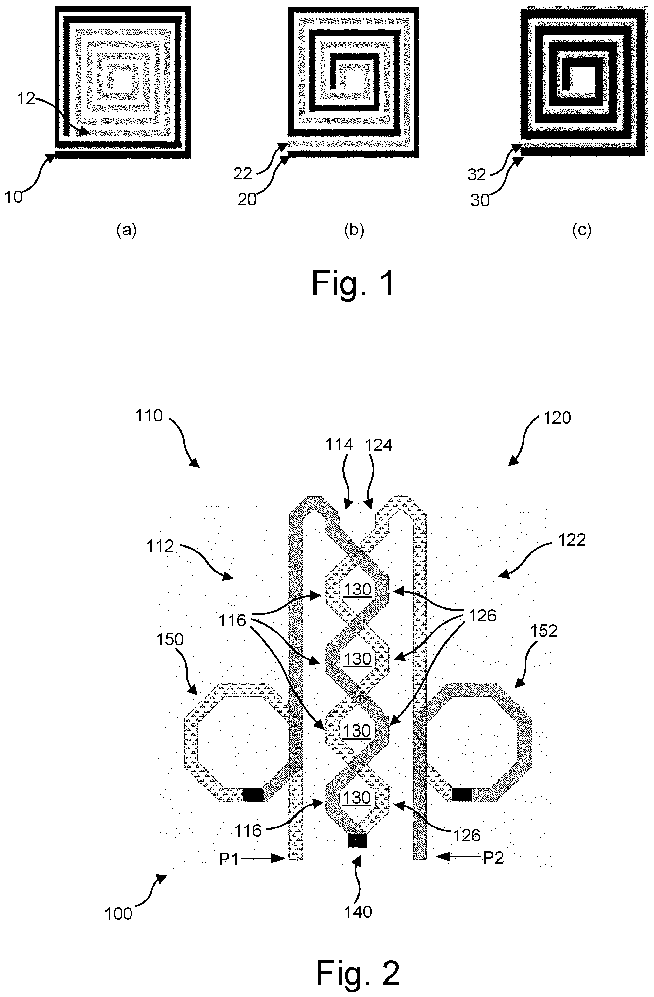

Architectures for on-chip monolithic transformers include parallel architecture (Shibata type), interleaved architecture (Frlan type), and stacked architecture (Finlay type). Figure 1(a) illustrates the Shibata type, in which the primary and secondary windings 10, 12 are provided as nested coils. This topology is easy to design but the total lengths of the primary and secondary windings are not equal. Hence the transformer turns ratio can differ from unity despite having the same number of turns of metal on each winding. Figure 1(b) illustrates the Frlan type, which partially eliminates this asymmetry by providing the primary and secondary windings 20, 22 as interleaved or bifilar coils. Figure 1(c) illustrates the Finlay type, in which the primary and secondary windings 30, 32 are provided as stacked coils. This requires less area than an interleaved architecture and hence allows higher coupling coefficients to be reached. However, the upper metal layer is generally much thicker than the intermediate metal layer, leading to higher electrical resistance and thus increased IL (Insertion Loss) of the upper winding. This can lead to an asymmetry in the electrical response of the transformer. Also, the upper winding is electrically shielded from the "conductive" substrate by the lower winding, and hence the parasitic capacitance to the substrate (and the associated dissipation) differs for each winding. In addition, there is a large parallel plate component to the capacitance between windings due to the overlapping metal layers, which limits the frequency response in view of mm-Wave applications.

However, existing techniques and architectures for designing transformers and auto-transformers having intermediate or high magnetic coupling coefficient are not suitable for applications requiring a weak (e.g., less than 0.1) and negative coupling coefficient. Low magnetic coupling coefficients cannot be achieved by simply increasing the separation of the primary and secondary windings in existing architectures as this leads to a large area and increased losses.

US 2019/068166A1 describes a phase shifter module, multiplexer/demultiplexer and communication apparatus. US 9159484 B2 describes an integrated circuit based transformer.

### SUMMARY OF THE DISCLOSURE

Aspects of the disclosure are set out in the accompanying claims. Combinations of features from the dependent claims may be combined with features of the independent claims as appropriate and not merely as explicitly set out in the claims.

According to an aspect of the disclosure, there is provided a transformer comprising:
a first conducting element having a first lobed portion arranged to form a first plurality of lobes; and
a second conducting element having a second lobed portion arranged to form a second plurality of lobes;
wherein said first lobed portion overlaps said second lobed portion to define a plurality of enclosed areas. The transformer is substantially symmetric. A number of lobes comprised by said first plurality of lobes is equal to a number of lobes comprised by said second plurality of lobes.

An advantage of the transformer of the present disclosure is that it may provide a transformer (including an autotransformer) having both a low absolute value of magnetic coupling coefficient, for example less than 0.1, and a relatively small area or footprint. The transformer may also have a negative magnetic coupling coefficient.

Successive lobes of the first plurality of lobes may be formed by portions of the first conducting element arranged to wind in opposite senses.

As a result, a current flowing in the first conducting element may produce a magnetic field in the plurality of enclosed areas which may be oriented in opposite directions in adjacent enclosed areas. This may also help to reduce the sensitivity of the transformer to coupling of external radiation. Similarly, successive lobes of the second plurality of lobes may be formed by portions of the second conducting element arranged to wind in opposite senses.

Each lobe of said first and/or second plurality of lobes may comprise only a partial turn of the respective conducting element.

In this way, each enclosed area of said plurality of enclosed areas may be defined by a partial turn of the first conducting element on one side, and a partial turn of the second conducting element on the other side. For example, each lobe may comprise a half turn of the respective conducting element. Adjacent enclosed areas of said plurality of enclosed areas may be separated by crossing points of said first and second conducting elements.

Said first lobed portion and said second lobed portion may together form a symmetric pattern.

By providing an even number of lobes, cancellation of magnetic fields at adjacent enclosed areas and immunity to coupling of environmental radiation may be improved.

**In** some embodiments, said first conducting element further comprises a first outer portion connected at one end to a first end of said first lobed portion, and said second conducting element further comprises a second outer portion connected at one end to a first end of said second lobed portion.

Said first outer portion and said first lobed portion may be arranged to form a first loop; and said second outer portion and said second lobed portion may be arranged to form a second loop, said second loop at least partially overlapping said first loop.

In some embodiments, at least a portion of said first outer portion and/or said second outer portion is substantially straight.

This may be helpful in reducing the overall area of the transformer.

In some embodiments, a second end of said first lobed portion is connected to a second end of said second lobed portion.

In this way, the transformer may be configured as an autotransformer. Advantageously, the connection between the second ends of the first and second lobed portion may provide convenient access for a center tap of the autotransformer. Said second end of said first lobed portion may be adjacent or overlapping said second end of said second lobed portion. For example said second ends of said first and second lobed portions may be located at a crossing point of said first and second conducting elements.

Said second end of said first lobed portion and said second end of said second lobed portion may be connected to ground, for example to a ground plane.

The connection to ground may be via a switch.

In some embodiments, the transformer is an autotransformer.

The first and second conducting elements may provide the primary and secondary sides respectively of the autotransformer, the first and second conducting elements being connected in series.

In some embodiments, said first outer element is further arranged to define a full turn of the first conducting element, and/or said second outer element is further arranged to define a full turn of the second conducting element.

Including a full turn in one or both of the first and second outer elements may facilitate optimising the design of the transformer for a specific application. to a specific frequency or frequency range depending on the application. However, these tuning elements may be omitted if required to reduce the footprint or overall area of the transformer.

The transformer may be formed on a substrate.

For example, the transformer of the present disclosure may be implemented as a planar monolithic transformer. For example, the transformer may be formed on a PCB or on any dielectric or semiconductor substrate, including silicon and GaN. The transformer may be implemented in an integrated circuit, for example an RFIC.

According to a further aspect of the present disclosure, there is provided a passive phase shifter comprising a transformer as defined above.

The transformer defined above may be particularly useful in applications where Phase-to-Gain must be minimised, for example in integrated 0/90° Passive Phase shifter (PPS) for analog beam-forming applications, which may require the Phase-to-Gain to vary by less than 0.5dB between the two modes, since this is only achievable for weak negative values of k, for example in the range -0.05 to -0.15.

### BRIEF DESCRIPTION OF THE DRAWINGS

Example embodiments of the present disclosure will be described, by way of example only, with reference to the accompanying drawings in which like reference signs relate to like elements and in which:
Figure 1 schematically illustrates various monolithic transformer architectures: (a) parallel windings, (b) interleaved windings, and (c) stacked windings;
Figure 2 shows a configuration of a transformer according to an example embodiment of the present disclosure;
Figure 3 shows a configuration of a transformer according to another example embodiment of the present disclosure;
Figure 4 illustrates a passive phase shifter comprising a transformer according to an example embodiment of the present disclosure; and
Figure 5 presents simulation results for (a) the individual inductances (top two traces) and mutual inductance (lower trace) of the primary and secondary sides of the transformer of Figure 2 (optimised for 28 GHz) as a function of frequency and (b) the resistances of the primary and secondary sides of the transformer of Figure 2 (optimised for 28 GHz) as a function of frequency.

### DETAILED DESCRIPTION

Figure 2 illustrates a configuration of a transformer 100, in the form of a planar monolithic autotransformer 100, according to an example embodiment of the present disclosure. The autotransformer 100 comprises a first conducting element 110 and a second conducting element 120, effectively forming the primary and secondary sides respectively of the autotransformer 100. The first conducting element 110 includes a first outer portion 112 and a first lobed portion 114, which together form a first loop. The first outer portion 112 extends from a first terminal P1 to a first end of the first lobed portion 114. Similarly, the second conducting element 120 includes a second outer portion 122 and a second lobed portion 124, which together form a second loop, the second outer portion 122 extending from a second terminal P2 to a first end of the second lobed portion 124. The first lobed portion 114 is arranged to form a first plurality of lobes 116, and the second lobed portion 124 is arranged to form a second plurality of lobes 126.

Each of the first and second pluralities of lobes 116, 126 corresponds to a sequence of partial turns of the respective conducting element 110, 120, with each successive lobe 116, 126 winding in an opposite sense to the preceding lobe 116, 126. The first and second conducting elements 110, 120 are arranged such that the first lobed portion 114 overlaps the second lobed portion 124 to define a plurality of enclosed areas 130. Each enclosed area 130 is bounded by a lobe 116 of the first conducting element 110 on one side, and by a lobe 126 of the second conducting element 120 on the other side, with adjacent enclosed areas 130 being separated by crossing points of said first and second conducting elements 110, 120.

A current flowing in the first lobed portion 114 thereby produces a magnetic field in each of the enclosed areas 130 which is opposite in direction to the magnetic field in adjacent enclosed areas 130.

In this embodiment, the respective second ends of the first and second lobed portions 114, 124 are connected to each other at a centre tap 140 to form an autotransformer. The centre tap 140 is connected to ground. Therefore the magnetic coupling between the respective lobes of the first and second lobed portions 114, 124 at each enclosed area 130 is negative. As a result, the magnetic coupling between the first and second lobed portions 114, 124 has a negative magnetic coupling coefficient k.

In this embodiment, the centre tap 140 is located at a crossing point of the first and second lobed portions 114, 124 to facilitate the connection. Being located at an end of the first and second lobed portions 114, 124 and between the first and second terminals P1, P2, the design of the transformer 100 provides convenient access to the centre tap 140.

In this embodiment, the first and second lobed portions 114, 124 have an equal and even number of lobes 116, 126, forming a symmetric pattern. This results in at least partial cancellation of the magnetic fields from adjacent pairs of enclosed areas 130, thereby reducing the sensitivity of the transformer to external radiation.

In the embodiment shown in Figure 2, the first and second lobed portions 114, 124 each comprise four lobes 116, 126, each comprising a half turn of the respective conducting member 110, 120. However, different numbers and shapes of lobes may be used, depending on the coupling strength required and the area available.

The first and second outer elements 112, 122 further include a respective tuning element 150, 152, in the form of a full turn of the respective first/second conducting element 110, 120. The tuning elements 150, 152 provide a means for convenient tuning of the transformer values for fine tuning and optimisation during the design stage. The dimensions of the tuning elements 150, 152 can be stretched in one or both of the vertical and horizontal directions (i.e., in the plane of the transformer 100), for example to optimise the transformer for a given frequency range. The shape of the loops of the tuning elements 150, 152 may also be varied. However, the tuning elements 150, 152 may be omitted if a particularly small footprint is required for the transformer.

The first and second tuning elements 150, 152 shown in Figure 2 are also coupled magnetically with a low negative coupling coefficient k, so the overall magnetic coupling coefficient of the autotransformer 100 is still negative.

In the embodiment shown in Figure 2, the first and second outer portions 112, 122 have straight portions, which may be helpful in reducing the overall area of the transformer 100. However, other configurations may be used.

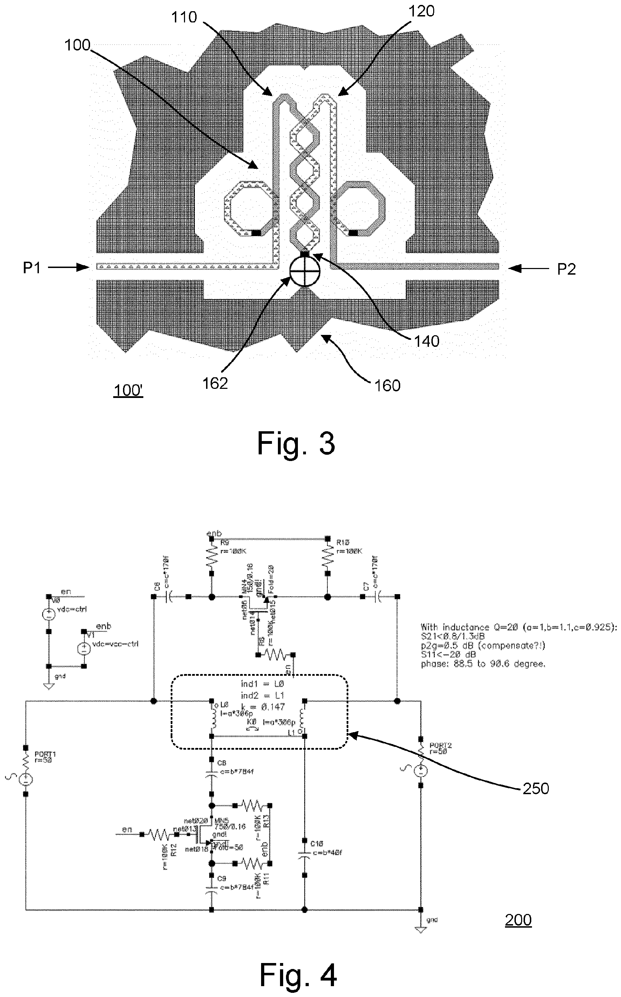

Figure 3 illustrates a transformer 100' according to another example embodiment of the disclosure. Elements corresponding to those of transformer 100 described above with reference to Figure 2 are labelled with identical reference numbers.

Figure 3 differs from Figure 2 in that the transformer 100 is shown surrounded by a ground plane 160. The transformer 100' is formed on a substrate, for example, any dielectric or semiconductor substrate, including silicon and GaN, or a PCB. The first and second conducting elements 110, 120 are formed by metallization on the substrate. An (n-1)th layer of metallization is used to form the parts of the conducting members 110, 120 indicated by a black and white pattern. An nth layer of metallization is used to form the parts of the conducting elements 110, 120 indicated by grey shading. In the present embodiment, the conducting elements 110, 120 are formed using only the angles (0, 45, 90 degrees) available in the GaN fabrication process. However, other angles and curvatures may be available in other processes. The ground plane 160 may be formed as part of the (n-1)th or nth layer of metallization, or as a lower layer. In the embodiment shown in Figure 3, the centre tap 140 is connected to the ground plane 160 by a switch 162. However, a permanent connection may be used depending on the application.

Importantly, the design of the transformer 100, 100' of the present disclosure is optimised to allow convenient access to the centre tap 140, enabling an easy and efficient ground connection in the present embodiment. Additionally, the first and second terminals P1, P2 are located symmetrically to each side of the transformer 100, facilitating routing of connections and thus minimizing loses.

Figure 4 illustrates a 0/90° Passive Phase shifter (PPS) 200 comprising an autotransformer 250 which may be implemented using the transformer 100, 100' described above with reference to Figures 2 and 3. For this application, an autotransformer 250 having a low, negative value of k is required to minimise losses. In addition, the input and output must be as close as possible for ease of routing and thus minimising losses. The layout must also be compliant with a low-impedance path to the ground reference.

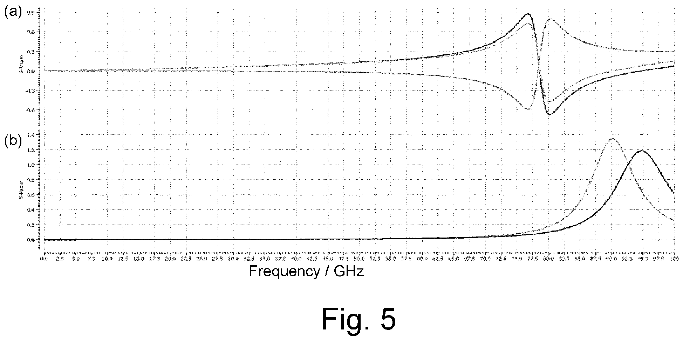

Figure 5 presents simulation results for the transformer 100, optimised for 28GHz. The upper graph shows the individual inductances (top two traces) and mutual inductance (lower trace) of the first and second conducting elements 110, 120 (i.e., the primary and secondary sides of the transformer) as a function of frequency. It can be seen that the inductances are substantially equal across a large frequency range, and that the mutual inductance is weak and negative, with an absolute value below 0.05. The lower graph of Figure 5 shows the resistances of the first and second conducting elements 110, 120 (i.e., the primary and secondary sides of the transformer) as a function of frequency. It can be seen that the resistances are substantially equal across a large frequency range. The transformer is operable over a wide frequency band and can be optimised for any frequency during the design phase, in particular by varying the area of the tuning elements 150, 152.

Whereas existing transformer designs are very area consuming or have a high magnetic coupling coefficient leading to high losses, the design of the transformer 100 of the present disclosure provides a transformer having a weak magnetic coupling coefficient, without consuming a high area and is therefore advantageous in applications requiring a low-k transformer. For example, the integrated 0/90° Passive Phase shifter (PPS) 200 requires a negatively-coupled autotransformer having a low absolute value of magnetic coupling coefficient k in order to achieve low absolute losses, a low difference in losses between the 0° and 90° modes (that is, a low Phase to Gain or P2G) and a low variation in phase shift ΔΦ between the 0° and 90° modes of the passive phase shifter 200 as a function of magnetic coupling coefficient k.

Accordingly, there has been described a transformer and an integrated passive phase shifter comprising the transformer. The transformer includes a first conducting element having a first lobed portion arranged to form a first plurality of lobes. The transformer includes a second conducting element having a second lobed portion arranged to form a second plurality of lobes. The first lobed portion overlaps said second lobed portion to define a plurality of enclosed areas.

Embodiments of the transformer include monolithic on-chip transformers. The transformer may be fully symmetrical. The transformer is particularly suitable for implementation as an autotransformer having a weak, negative magnetic coupling.

Although particular example embodiments of the disclosure have been described above, it will be appreciated than many modifications, including additions and/or substitutions, may be made within the scope of the appended claims.

## Claims

1. A transformer (100, 100') comprising:
a first conducting element (110) having a first lobed portion (114) arranged to form a first plurality of lobes (116); and
a second conducting element (120) having a second lobed portion (124) arranged to form a second plurality of lobes (126);
wherein said first lobed portion (114) overlaps said second lobed portion (124) to define a plurality of enclosed areas (130),
**characterised in that** the number of lobes comprised by said first plurality of lobes (116) is an even number, and said transformer (100, 100') is substantially symmetric.

2. The transformer (100, 100') according to claim 1, wherein successive lobes of the first plurality of lobes (116) are formed by portions of the first conducting element (110) arranged to wind in opposite senses.

3. The transformer (100, 100') according to claim 1 or claim 2, wherein each lobe of said first and/or second plurality of lobes (116, 126) comprises only a partial turn of the respective conducting element (110, 120).

4. The transformer (100, 100') according to any one of the preceding claims, wherein a number of lobes comprised by said first plurality of lobes (116) is equal to a number of lobes comprised by said second plurality of lobes (126).

5. The transformer (100, 100') according to any one of the preceding claims, wherein
said first conducting element further comprises a first outer portion (112) connected at one end to a first end of said first lobed portion (114), and
said second conducting element further comprises a second outer portion (122) connected at one end to a first end of said second lobed portion (124).

6. The transformer (100, 100') according to claim 5, wherein
said first outer portion (112) and said first lobed portion (114) are arranged to form a first loop; and
said second outer portion (122) and said second lobed portion (124) are arranged to form a second loop, said second loop at least partially overlapping said first loop.

7. The transformer (100, 100') according to claim 5 or claim 6, wherein at least a portion of said first outer portion (112) and/or said second outer portion (122) is substantially straight.

8. The transformer (100, 100') according to any one of the preceding claims, wherein a second end of said first lobed portion (114) is connected to a second end of said second lobed portion (124).

9. The transformer (100, 100') according to claim 9, wherein said second end of said first lobed portion (114) and said second end of said second lobed portion (124) are connected to ground.

10. The transformer (100, 100') according to any one of the preceding claims, wherein said transformer is an autotransformer.

11. The transformer (100, 100') according to any one of claims 5 to 7, wherein
said first outer portion (112) is further arranged to define a full turn of the first conducting element, and/or
said second outer portion (122)is further arranged to define a full turn of the second conducting element.

12. The transformer (100, 100') according to any one of the preceding claims, wherein said transformer (100, 100') is formed on a substrate.

13. A passive phase shifter comprising a transformer (100, 100') according to any one of the preceding claims.

## Patentansprüche

1. Transformator (100, 100'), der Folgendes umfasst:
ein erstes leitendes Element (110) mit einem ersten ausgebuchteten Abschnitt (114), der so angeordnet ist, dass er eine erste Vielzahl von Ausbuchtungen (116) bildet; und
ein zweites leitendes Element (120) mit einem zweiten ausgebuchteten Abschnitt (124), der so angeordnet ist, dass er eine zweite Vielzahl von Ausbuchtungen (126) bildet;
wobei der erste ausgebuchtete Abschnitt (114) den zweiten ausgebuchteten Abschnitt (124) überlappt, um eine Vielzahl umschlossener Bereiche (130) zu definieren, **dadurch gekennzeichnet, dass** die Anzahl von von der ersten Vielzahl von Ausbuchtungen (116) umfassten Ausbuchtungen eine gerade Zahl ist und der Transformator (100, 100') im Wesentlichen symmetrisch ist.

2. Transformator (100, 100') nach Anspruch 1, wobei aufeinanderfolgende Ausbuchtungen der ersten Vielzahl von Ausbuchtungen (116) von Abschnitten des ersten leitenden Elements (110), die so angeordnet sind, dass sie sich gegenläufig winden, gebildet werden.

3. Transformator (100, 100') nach Anspruch 1 oder Anspruch 2, wobei jede Ausbuchtung der ersten und/oder der zweiten Vielzahl von Ausbuchtungen (116, 126) nur eine Teilwindung des jeweiligen leitenden Elements (110, 120) umfasst.

4. Transformator (100, 100') nach einem der vorhergehenden Ansprüche, wobei eine Anzahl von von der ersten Vielzahl von Ausbuchtungen (116) umfassten Ausbuchtungen gleich einer Anzahl von von der zweiten Vielzahl von Ausbuchtungen umfassten Ausbuchtungen (126) ist.

5. Transformator (100, 100') nach einem der vorhergehenden Ansprüche, wobei
das erste leitende Element ferner einen ersten äußeren Abschnitt (112) umfasst, der an einem Ende mit einem ersten Ende des ersten ausgebuchteten Abschnitts (114) verbunden ist, und
das zweite leitende Element ferner einen zweiten äußeren Abschnitt (122) umfasst, der an einem Ende mit einem ersten Ende des zweiten ausgebuchteten Abschnitts (124) verbunden ist.

6. Transformator (100, 100') nach Anspruch 5, wobei
der erste äußere Abschnitt (112) und der erste ausgebuchtete Abschnitt (114) so angeordnet sind, dass sie eine erste Schleife bilden; und
der zweite äußere Abschnitt (122) und der zweite ausgebuchtete Abschnitt (124) so angeordnet sind, dass sie eine zweite Schleife bilden, wobei die zweite Schleife die erste Schleife zumindest teilweise überlappt.

7. Transformator (100, 100') nach Anspruch 5 oder Anspruch 6, wobei mindestens ein Abschnitt des ersten äußeren Abschnitts (112) und/oder des zweiten äußeren Abschnitts (122) im Wesentlichen gerade ist.

8. Transformator (100, 100') nach einem der vorhergehenden Ansprüche, wobei ein zweites Ende des ersten ausgebuchteten Abschnitts (114) mit einem zweiten Ende des zweiten ausgebuchteten Abschnitts (124) verbunden ist.

9. Transformator (100, 100') nach Anspruch 9, wobei das zweite Ende des ersten ausgebuchteten Abschnitts (114) und das zweite Ende des zweiten ausgebuchteten Abschnitts (124) an Masse gelegt sind.

10. Transformator (100, 100') nach einem der vorhergehenden Ansprüche, wobei der Transformator ein Autotransformator ist.

11. Transformator (100, 100') nach einem der Ansprüche 5 bis 7, wobei
der erste äußere Abschnitt (112) ferner so angeordnet ist, dass er eine vollständige Windung des ersten leitenden Elements definiert, und/oder
der zweite äußere Abschnitt (122) ferner so angeordnet ist, dass er eine vollständige Windung des zweiten leitenden Elements definiert.

12. Transformator (100, 100') nach einem der vorhergehenden Ansprüche, wobei der Transformator (100, 100') auf einem Substrat gebildet ist.

13. Passiver Phasenschieber, der einen Transformator (100, 100') nach einem der vorhergehenden Ansprüche umfasst.

## Revendications

1. Transformateur (100, 100') comprenant :
un premier élément conducteur (110) ayant une première portion lobée (114) agencée pour former une première pluralité de lobes (116) ; et
un deuxième élément conducteur (120) ayant une deuxième portion lobée (124) agencée pour former une deuxième pluralité de lobes (126) ;
ladite première portion lobée (114) chevauchant ladite deuxième portion lobée (124) pour définir une pluralité de zones enfermées (130), **caractérisé en ce que** le nombre de lobes constitué par ladite première pluralité de lobes (116) est un nombre pair, et ledit transformateur (100, 100') est substantiellement symétrique.

2. Transformateur (100, 100') selon la revendication 1, dans lequel des lobes successifs de la première pluralité de lobes (116) sont formés par des portions du premier élément conducteur (110) agencées pour s'enrouler dans des sens opposés.

3. Transformateur (100, 100') selon la revendication 1 ou la revendication 2, dans lequel chaque lobe de ladite première et/ou deuxième pluralité de lobes (116, 126) constitue uniquement un tour partiel de l'élément conducteur respectif (110, 120).

4. Transformateur (100, 100') selon l'une quelconque des revendications précédentes, dans lequel un nombre de lobes constitué par ladite première pluralité de lobes (116) est égal à un nombre de lobes constitué par ladite deuxième pluralité de lobes (126).

5. Transformateur (100, 100') selon l'une quelconque des revendications précédentes, dans lequel
ledit premier élément conducteur comprend en outre une première portion externe (112) connectée au niveau d'une extrémité à une première extrémité de ladite première portion lobée (114), et
ledit deuxième élément conducteur comprend en outre une deuxième portion externe (122) connectée au niveau d'une extrémité à une première extrémité de ladite deuxième portion lobée (124).

6. Transformateur (100, 100') selon la revendication 5, dans lequel
ladite première portion externe (112) et ladite première portion lobée (114) sont agencées pour former une première boucle ; et
ladite deuxième portion externe (122) et ladite deuxième portion lobée (124) sont agencées pour former une deuxième boucle, ladite deuxième boucle chevauchant au moins partiellement ladite première boucle.

7. Transformateur (100, 100') selon la revendication 5 ou la revendication 6, dans lequel au moins une portion de ladite première portion externe (112) et/ou de ladite deuxième portion externe (122) est substantiellement droite.

8. Transformateur (100, 100') selon l'une quelconque des revendications précédentes, dans lequel une deuxième extrémité de ladite première portion lobée (114) est connectée à une deuxième extrémité de ladite deuxième portion lobée (124).

9. Transformateur (100, 100') selon la revendication 9, dans lequel ladite deuxième extrémité de ladite première portion lobée (114) et ladite deuxième extrémité de ladite deuxième portion lobée (124) sont connectées à la terre.

10. Transformateur (100, 100') selon l'une quelconque des revendications précédentes, ledit transformateur étant un autotransformateur.

11. Transformateur (100, 100') selon l'une quelconque des revendications 5 à 7, dans lequel
ladite première portion externe (112) est en outre agencée pour définir un tour complet du premier élément conducteur, et/ou
ladite deuxième portion externe (122) est en outre agencée pour définir un tour complet du premier élément conducteur.

12. Transformateur (100, 100') selon l'une quelconque des revendications précédentes, ledit transformateur (100, 100') étant formé sur un substrat.

13. Déphaseur passif comprenant un transformateur (100, 100') selon l'une quelconque des revendications précédentes.
